# EUROPEAN PATENT SPECIFICATION

(11) **EP 4 386 837 B1**
(45) Date of publication and mention of the grant of the patent: **07.10.2026**
(21) Application number: 23202736.7
(22) Date of filing: 10.10.2023
(51) Int. Cl.: H02M 3/00, H02M 1/00, H02M 1/32, H02M 7/00, H10W 70/60, H10W 90/00

(54) **POWER APPARATUS**
LEISTUNGSVORRICHTUNG
APPAREIL DE PUISSANCE

(30) Priority: 15.12.2022 TW 111148288
(43) Date of publication of application: 19.06.2024
(73) Proprietor: SENTEC E&E CO., LTD., Taoyuan City 325019 (TW)
(72) Inventor: HUANG, Jason, Taoyuan City 325019 (TW); CHEN, Liang-Yo, Taoyuan City 325019 (TW); HSU, Pi-Sheng, Taoyuan City 325019 (TW)
(74) Representative: 2K Patent Partnerschaft mbB

(56) References cited:
- CN-U- 220 233 181
- US-A1- 2013 075 932
- US-A1- 2019 295 990
- US-B2- 10 917 992

## Description

### BACKGROUND OF THE DISCLOSURE

### Technical Field

The present disclosure relates to a power apparatus, and especially relates to a power apparatus that effectively reduces the stray inductance.

### Description of Related Art

US 2013/075932 A1 discloses a power semiconductor module which includes a first printed circuit board having a first insulation carrier, and a first upper metallization and a first lower metallization applied to the first insulation carrier on mutually opposite sides, and a second printed circuit board having a second insulation carrier and a second upper metallization applied to the second insulation carrier. The second printed circuit board is spaced apart from the first printed circuit board in a vertical direction oriented perpendicular to the opposite sides of the first insulation carrier. A semiconductor chip is disposed between the printed circuit boards and electrically conductively connected at least to the second upper metallization. The first lower metallization and the second upper metallization face one another. The first printed circuit board has a first thick conductor layer at least partly embedded in the first insulation carrier and which has a thickness of at least 100 µm.

US 2019/295990 A1 discloses a semiconductor power module including an insulating substrate having one surface and another surface, an output side terminal arranged at a one surface side of the insulating substrate, a first power supply terminal arranged at the one surface side of the insulating substrate, a second power supply terminal to which a voltage of a magnitude different from a voltage applied to the first power supply terminal is to be applied, and arranged at another surface side of the insulating substrate so as to face the first power supply terminal across the insulating substrate, a first switching device arranged at the one surface side of the insulating substrate and electrically connected to the output side terminal and the first power supply terminal, and a second switching device arranged at the one surface side of the insulating substrate and electrically connected to the output side terminal and the second power supply terminal.

A power apparatus operating in power conversion usually involves a certain degree of voltage or current. According to the principle of electromagnetic induction, unnecessary noise or energy loss (such as the switching loss, and so on) may easily occur when the switches of the power apparatus are switched. Especially at the moment when the transistor turns off and suddenly turns on, it is easy to cause voltage spikes (or voltage glitches, and so on) due to the stray inductance generated by the long current path. Not only does it cause the energy loss, but it may also cause the damage to the components of the power apparatus, affecting the operating efficiency and reliability.

Therefore, how to design a power apparatus to solve the aforementioned technical problems is an important topic studied by the applicant of the present disclosure.

### SUMMARY OF THE DISCLOSURE

An object of the present disclosure is to provide a power apparatus that may solve the technical problem of voltage spikes caused by the stray inductance in the current paths in the related art, and may effectively avoid the energy loss and the device damage of the power apparatus, and may achieve the purpose of improving the operating efficiency and reliability.

In order to achieve the object mentioned above, a power apparatus according to claim 1 is provided by the present disclosure. It includes a substrate, a first power component, a second power component, and a connection board. The substrate includes a first area and a second area separated from each other. The first power component is arranged on the first area. The second power component is arranged on the second area. The connection board is arranged between the first area and the second area, and is electrically connected to the first power component and the second area respectively.

The connection board includes a base material layer, a first transmission layer, and a second transmission layer which are stacked on each other. The base material layer is sandwiched between the first transmission layer and the second transmission layer. The first transmission layer is electrically connected to the first power component and the second area respectively. The substrate further includes a third area. The third area is separated from the first area and the second area. The first power component, the first transmission layer, the second area, and the second power component form a first current path.

The power apparatus further includes a first transmission line and a second transmission line. The first transmission line is electrically connected to one end of the second transmission layer and the third area of the substrate. The second transmission line is electrically connected to the other end of the second transmission layer and the second power component. The third area is separated from the first area and the second area. The second power component, the second transmission line, the second transmission layer, the first transmission line, and the third area form a second current path. The second current path is parallel to and opposite to the first current path.

Advantageous embodiments are the subject of the dependent claims.

In some embodiments, the power apparatus further includes a first gate resistor and a second gate resistor. The first gate resistor is electrically connected to the first power component. The second gate resistor is electrically connected to the second power component.

In some embodiments, the third area, the first transmission layer, and the first power component form a third current path; the third current path and the first current path are in series and in the same direction. The first gate resistor is arranged on the second transmission layer.

To sum up, when the power apparatus of the present disclosure is used, the first power component and the second power component may be arranged on the metallization areas (for example, the first area and the second area) on the substrate; by connecting to different metallization areas through the connection board, the first power component may be electrically connected to the second power component through the connection board. In the related art, wire bonding is usually used to connect various metallization areas; however, this method not only extends the current path between different metallization areas, but also increases energy consumption and noise; in addition, the insufficient mechanical strength of wire bonding has caused reliability problems. The present disclosure uses the solution of the connection board, which may provide reliable mechanical strength between different metallization areas. Compared with parabolic wiring, the connection board which is flat-shaped of the present disclosure may effectively shorten the current paths between different metallization areas, which may reduce the stray inductance and the phenomenon of the voltage spikes.

Therefore, the power apparatus of the present disclosure may solve the technical problem of voltage spikes caused by the stray inductance in current paths in related art, and may effectively avoid the energy loss and the device damage of the power apparatus, and may achieve the purpose of improving the operating efficiency and reliability.

Please refer to the detailed descriptions and figures of the present disclosure mentioned below for further understanding the technology, method and effect of the present disclosure achieving the predetermined purposes. It believes that the characteristics and features of the present disclosure may be understood deeply and specifically. However, the figures are only for references and descriptions, but the present disclosure is not limited by the figures.

### BRIEF DESCRIPTION OF THE DRAWINGS

Fig. 1 shows a schematic diagram of the appearance of the power apparatus according to the first embodiment of the present disclosure.
Fig. 2 shows a schematic diagram of the cross-sectional view of the power apparatus according to the first embodiment of the present disclosure.
Fig. 3 shows an exploded schematic view of the connection board according to the first embodiment of the present disclosure.
Fig. 4 shows a schematic diagram of the appearance of the power apparatus according to the second embodiment of the present disclosure.
Fig. 5 shows a schematic diagram of the cross-sectional view of the power apparatus according to the second embodiment of the present disclosure.
Fig. 6 shows an exploded schematic view of the connection board according to the second embodiment of the present disclosure.

### DETAILED DESCRIPTION

The following content illustrates the implementation of the present disclosure through specific embodiments. Those familiar with this technology may easily understand other advantages and effects of the present disclosure from the content disclosed in this specification. The present disclosure may also be implemented or applied through other different specific embodiments. Various details in the description of the present disclosure may also be modified and changed in various ways based on different viewpoints and applications without departing from the spirit of the present disclosure.

It should be noted that the structure, proportion, size, number of components, and so on shown in the drawings attached to this specification are only used to match the content disclosed in the specification and are for the understanding and reading of those familiar with this technology, which are not intended to limit the implementation of the present disclosure, and therefore have no technical substantive significance. The scope of the invention is limited by the claims.

The technical content and detailed description of the present disclosure are described as following with reference to the drawings.

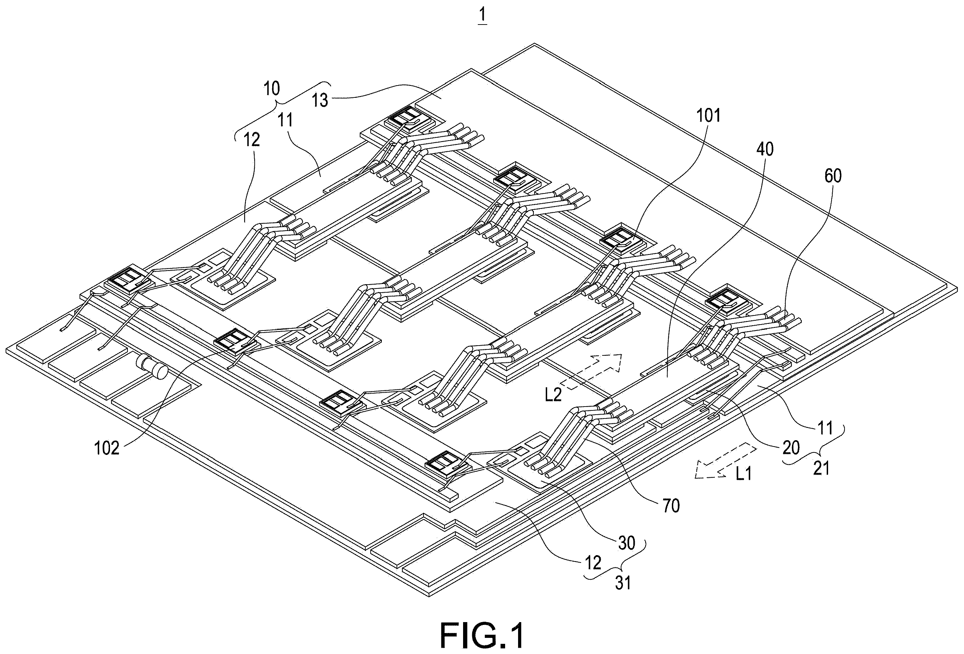

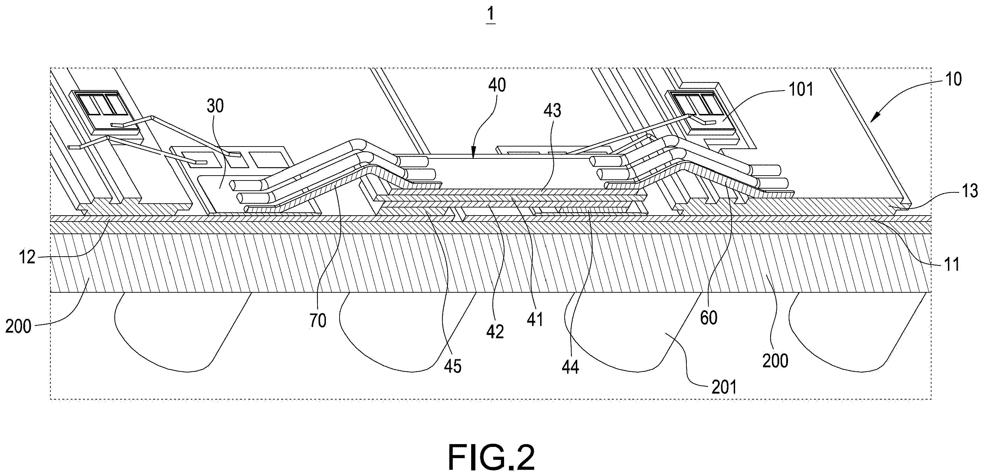

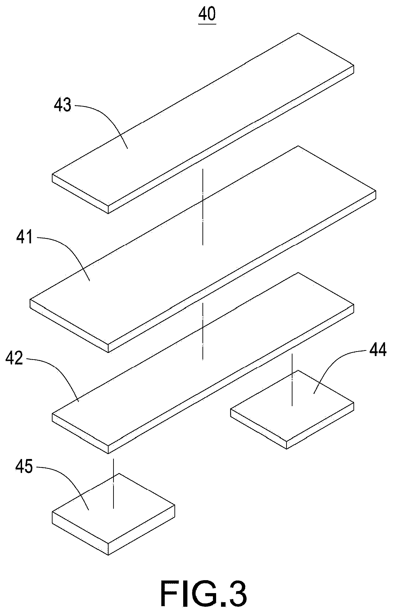

Fig. 1 shows a schematic diagram of the appearance of the power apparatus according to the first embodiment of the present disclosure. Fig. 2 shows a schematic diagram of the cross-sectional view of the power apparatus according to the first embodiment of the present disclosure. Fig. 3 shows an exploded schematic view of the connection board according to the first embodiment of the present disclosure.

Please refer to Fig. 1 to Fig. 3 together. The power apparatus 1 according to the first embodiment provided by the present disclosure includes a substrate 10, a first power component 20, a second power component 30, and a connection board 40.

The substrate 10 includes a first area 11 and a second area 12 which are separated from each other.

In some embodiments, the substrate 10 may include sapphire, polyethylene terephthalate (positron emission tomography, PET), bismaleimide triazine resin (also known as BT resin), or ceramic (for example, alumina (Al₂O₃)), and other materials. Furthermore, the substrate 10 may be a printed circuit board (PCB), a circuitized ceramic substrate, or a chip leadframe, and so on, but the present disclosure is not limited by it.

In some embodiments, the first area 11 and the second area 12 are metallization areas which are separated from each other, but the present disclosure is not limited by it.

In some embodiments, the substrate 10 further includes a third area 13, which is separated from the first area 11 and the second area 12, but the present disclosure is not limited by it.

In some embodiments, a heat sink 200 may be arranged on a bottom surface of the substrate 10. The heat sink 200 assists in the heat dissipation of the substrate 10. The heat sink 200 forms a plurality of heat dissipation columns 201 to increase the effective heat dissipation area and enhance the heat dissipation efficiency, but the present disclosure is not limited by it.

The first power component 20 is arranged on the first area 11.

In some embodiments, the first area 11 and the first power component 20 form the first power circuit 21, but the present disclosure is not limited by it. Furthermore, the first power component 20 may include different types of transistors or switching components, and so on, but the present disclosure is not limited by it.

The second power component 30 is arranged on the second area 12.

In some embodiments, the second area 12 and the second power component 30 form the second power circuit 31, but the present disclosure is not limited by it. Furthermore, the second power component 30 may include different types of transistors or switching components, and so on, but the present disclosure is not limited by it.

The connection board 40 is arranged between the first area 11 and the second area 12, and is electrically connected to the first power component 20 and the second area 12 respectively.

In some embodiments, the connection board 40 includes a base material layer 41, a first transmission layer 42, and a second transmission layer 43 which are stacked on each other.

The base material layer 41 is sandwiched between the first transmission layer 42 and the second transmission layer 43. The first transmission layer 42 is electrically connected to the first power component 20 and the second area 12 respectively.

In some embodiments, the base material layer 41 may include sapphire, polyethylene terephthalate (positron emission tomography, PET), bismaleimide triazine resin (also known as BT resin), or ceramic (for example, alumina (Al₂O₃)), and other materials, but the present disclosure is not limited by it.

In some embodiments, the first transmission layer 42 and the second transmission layer 43 may be made of highly conductive materials (for example, gold, silver, copper, and so on), but the present disclosure is not limited by it.

In some embodiments, the connection board 40 further includes a first connection pad 44 and a second connection pad 45.

The first connection pad 44 and the second connection pad 45 are respectively arranged at two opposite ends of the first transmission layer 42, and the first connection pad 44 is electrically connected to the first power component 20, and the second connection pad 45 is electrically connected to the second area 12, but the present disclosure is not limited by it.

In some embodiments, the first power component 20, the first transmission layer 42, the second area 12, and the second power component 30 form a first current path L1, but the present disclosure is not limited by it.

In some embodiments, the power apparatus 1 further includes a first transmission line 60 and a second transmission line 70.

The first transmission line 60 is electrically connected to one end of the second transmission layer 43 and the third area 13 of the substrate 10. The second transmission line 70 is electrically connected to the other end of the second transmission layer 43 and the second power component 30.

In some embodiments, the first transmission line 60 and the second transmission line 70 may be made of highly conductive materials (for example, gold, silver, copper, and so on), but the present disclosure is not limited by it.

In some embodiments, the second power component 30, the second transmission line 70, the second transmission layer 43, the first transmission line 60, and the third area 13 form a second current path L2, and the second current path L2 is parallel to and opposite to the first current path L1, but the present disclosure is not limited by it.

It is worth mentioning that according to Faraday's law of electromagnetic induction, this will cause the first magnetic field generated by the first current path L1 and the second magnetic field generated by the second current path L2 to be opposite to each other and to offset each other, thereby reducing or eliminating the electromagnetic interference between the first power component 20 and the second power component 30 as much as possible, and reducing the switching loss.

In some embodiments, the power apparatus 1 further includes a first gate resistor 101 and a second gate resistor 102, and the first gate resistor 101 is electrically connected to the first power component 20, and the second gate resistor 102 is electrically connected to the second power component 30, but the present disclosure is not limited by it.

Therefore, when the power apparatus 1 of the present disclosure is used, the first power component 20 and the second power component 30 may be arranged on the metallization areas (for example, the first area 11 and the second area 12) on the substrate 10; by connecting to different metallization areas through the connection board 40, the first power component 20 may be electrically connected to the second power component 30 through the connection board 40. In the related art, wire bonding is usually used to connect various metallization areas; however, this method not only extends the current path between different metallization areas, but also increases energy consumption and noise; in addition, the insufficient mechanical strength of wire bonding has caused reliability problems. The present disclosure uses the solution of the connection board 40, which may provide reliable mechanical strength between different metallization areas. Compared with parabolic wiring, the connection board 40 which is flat-shaped of the present disclosure may effectively shorten the current paths between different metallization areas, which may reduce the stray inductance and the phenomenon of the voltage spikes.

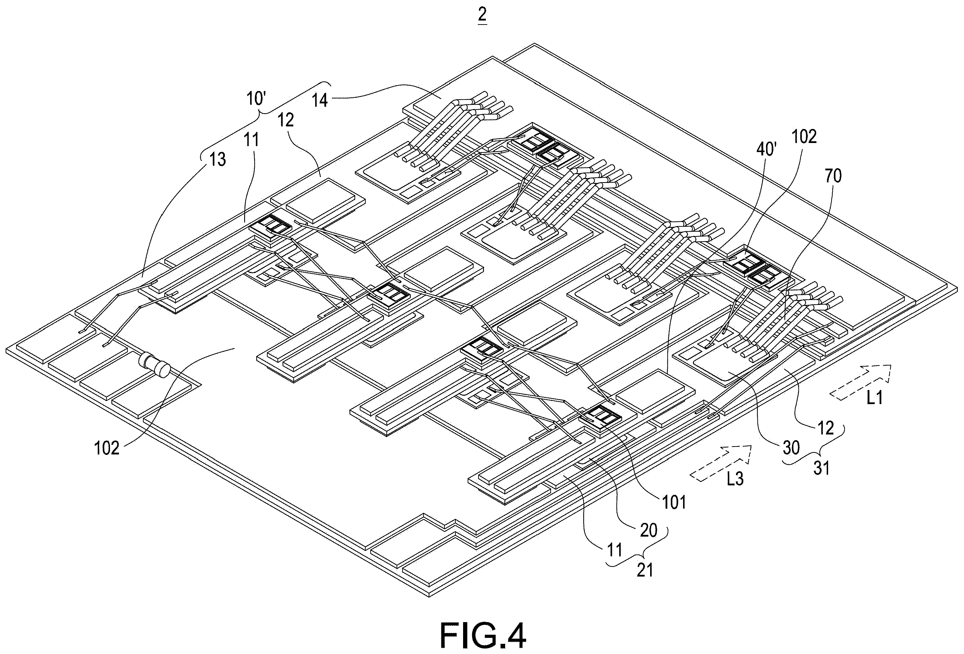

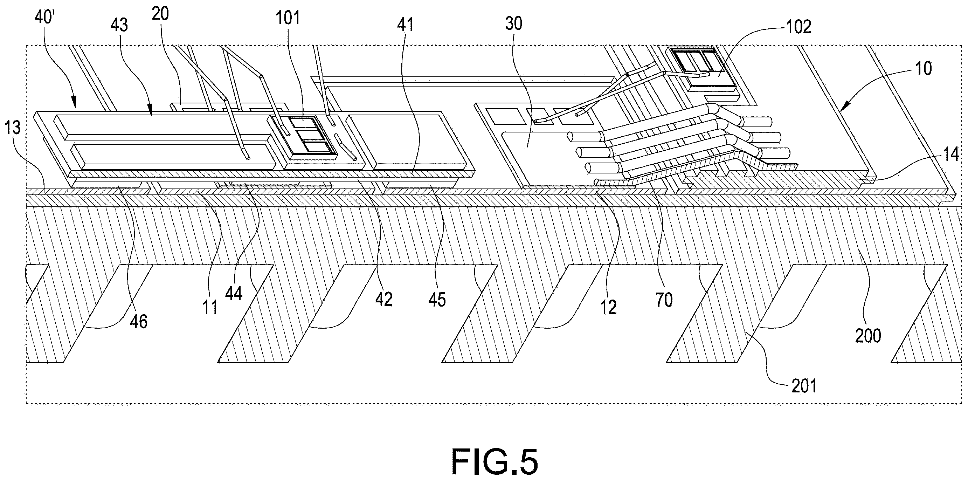

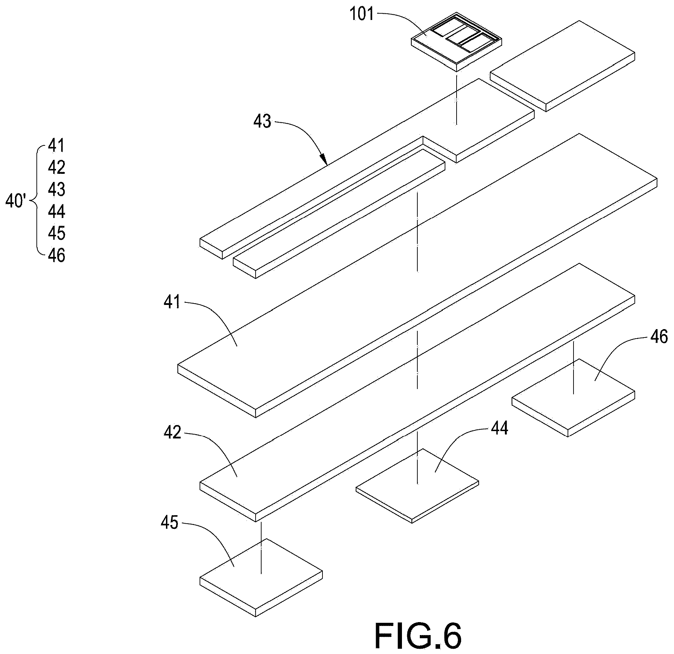

Fig. 4 shows a schematic diagram of the appearance of the power apparatus according to the second embodiment of the present disclosure. Fig. 5 shows a schematic diagram of the cross-sectional view of the power apparatus according to the second embodiment of the present disclosure. Fig. 6 shows an exploded schematic view of the connection board according to the second embodiment of the present disclosure.

Please refer to Fig. 4 to Fig. 6 together. The power apparatus 2 according to the second embodiment provided by the present disclosure is substantially the same as the power apparatus 1 according to the first embodiment mentioned above, except that the connection board 40' further includes a third connection pad 46. The configuration on the substrate 10' is slightly different from the configuration on the substrate 10 of the first embodiment mentioned above, and the second transmission line 70 is not connected to the connection board 40'.

The third connection pad 46 is electrically connected to the third area 13, and is electrically connected to the first connection pad 44 and the second connection pad 45 through the first transmission layer 42, and the second transmission line 70 may be connected to the second power element 30 and the fourth area 14 of the substrate 10, but the present disclosure is not limited by it.

In some embodiments, the third area 13, the first transmission layer 42, and the first power component 20 form a third current path L3, and the third current path L3 and the first current path L1 are in series and in the same direction, but the present disclosure is not limited by it.

In some embodiments, the first gate resistor 101 is arranged on the second transmission layer 43 to save the wiring space, but the present disclosure is not limited by it.

Therefore, when the power apparatus 2 of the present disclosure is used, the first power component 20 and the second power component 30 may be arranged on the metallization areas (for example, the first area 11 and the second area 12) on the substrate 10'; by connecting to different metallization areas through the connection board 40, the first power component 20 may be electrically connected to the second power component 30 through the connection board 40. In the related art, wire bonding is usually used to connect various metallization areas; however, this method not only extends the current path between different metallization areas, but also increases energy consumption and noise; in addition, the insufficient mechanical strength of wire bonding has caused reliability problems. The present disclosure uses the solution of the connection board 40', which may provide reliable mechanical strength between different metallization areas. Compared with parabolic wiring, the connection board 40' which is flat-shaped of the present disclosure may effectively shorten the current paths between different metallization areas, which may reduce the stray inductance and the phenomenon of the voltage spikes.

It is worth mentioning that one of the transmission lines (for example, the first transmission line 60) may be reduced by adding the third connection pad 46 to the connection board 40'. The first gate resistor 101 may be considered to be arranged on the second transmission layer 43 to save the wiring space.

To sum up, when the power apparatus of the present disclosure is used, the first power component and the second power component may be arranged on the metallization areas (for example, the first area and the second area) on the substrate; by connecting to different metallization areas through the connection board, the first power component may be electrically connected to the second power component through the connection board. In the related art, wire bonding is usually used to connect various metallization areas; however, this method not only extends the current path between different metallization areas, but also increases energy consumption and noise; in addition, the insufficient mechanical strength of wire bonding has caused reliability problems. The present disclosure uses the solution of the connection board, which may provide reliable mechanical strength between different metallization areas. Compared with parabolic wiring, the connection board which is flat-shaped of the present disclosure may effectively shorten the current paths between different metallization areas, which may reduce the stray inductance and the phenomenon of the voltage spikes.

It is worth mentioning that one of the transmission lines (for example, the first transmission line) may be reduced by adding the third connection pad to the connection board. The first gate resistor may be considered to be arranged on the second transmission layer to save the wiring space.

Therefore, the power apparatus of the present disclosure may solve the technical problem of voltage spikes caused by the stray inductance in current paths in related art, and may effectively avoid energy loss and device damage of the power apparatus, and may achieve the purpose of improving the operating efficiency and reliability.

## Claims

1. A power apparatus (1, 2) comprising:
a substrate (10, 10') comprising a first area (11) and a second area (12) separated from each other;
a first power component (20) arranged on the first area (11);
a second power component (30) arranged on the second area (12); and
a connection board (40, 40') arranged between the first area (11) and the second area (12), and electrically connected to the first power component (20) and the second area (12) respectively;
wherein the connection board (40, 40') comprises a base material layer (41), a first transmission layer (42), and a second transmission layer (43) stacked on each other; the base material layer (41) is sandwiched between the first transmission layer (42) and the second transmission layer (43); the first transmission layer (42) is electrically connected to the first power component (20) and the second area (12) respectively; the substrate (10, 10') further comprises a third area (13); the third area (13) is separated from the first area (11) and the second area (12); the first power component (20), the first transmission layer (42), the second area (12), and the second power component (30) form a first current path (L1);
**characterized in that** the power apparatus (1, 2) further comprises:
a first transmission line (60) electrically connected to one end of the second transmission layer (43) and the third area (13) of the substrate (10, 10'); and
a second transmission line (70) electrically connected to the other end of the second transmission layer (43) and the second power component (30),
wherein the third area (13) is separated from the first area (11) and the second area (12); the second power component (30), the second transmission line (70), the second transmission layer (43), the first transmission line (60), and the third area (13) form a second current path (L2); the second current path (L2) is parallel to and opposite to the first current path (L1).

2. The power apparatus (1, 2) of claim 1, further comprising:
a first gate resistor (101) electrically connected to the first power component (20); and
a second gate resistor (102) electrically connected to the second power component (30).

3. The power apparatus (1, 2) of claim 2, wherein the third area (13), the first transmission layer (42), and the first power component (20) form a third current path (L3); the third current path (L3) and the first current path (LL1) are in series and in a same direction; the first gate resistor (101) is arranged on the second transmission layer (43).

## Patentansprüche

1. Leistungsvorrichtung (1, 2), umfassend:
ein Substrat (10, 10'), das einen ersten Bereich (11) und einen zweiten Bereich (12) umfasst, die voneinander getrennt sind;
ein erstes Leistungsbauelement (20), das auf dem ersten Bereich (11) angeordnet ist;
ein zweites Leistungsbauelement (30), das auf dem zweiten Bereich (12) angeordnet ist; und
eine Verbindungsplatte (40, 40'), die zwischen dem ersten Bereich (11) und dem zweiten Bereich (12) angeordnet und jeweils elektrisch mit dem ersten Leistungsbauelement (20) und dem zweiten Bereich (12) verbunden ist;
wobei die Verbindungsplatte (40, 40') eine Basismaterialschicht (41), eine erste Übertragungsschicht (42) und eine zweite Übertragungsschicht (43) umfasst, die übereinander geschichtet sind; die Basismaterialschicht (41) zwischen der ersten Übertragungsschicht (42) und der zweiten Übertragungsschicht (43) angeordnet ist; die erste Übertragungsschicht (42) ist jeweils elektrisch mit dem ersten Leistungsbauelement (20) und dem zweiten Bereich (12) verbunden; das Substrat (10, 10') umfasst ferner einen dritten Bereich (13); der dritte Bereich (13) ist vom ersten Bereich (11) und vom zweiten Bereich (12) getrennt; das erste Leistungsbauelement (20), die erste Übertragungsschicht (42), der zweite Bereich (12) und das zweite Leistungsbauelement (30) bilden einen ersten Strompfad (L1);
**dadurch gekennzeichnet, dass** die Leistungsvorrichtung (1, 2) ferner umfasst:
eine erste Übertragungsleitung (60), die elektrisch mit einem Ende der zweiten Übertragungsschicht (43) und dem dritten Bereich (13) des Substrats (10, 10') verbunden ist; und
eine zweite Übertragungsleitung (70), die elektrisch mit dem anderen Ende der zweiten Übertragungsschicht (43) und dem zweiten Leistungsbauelement (30) verbunden ist,
wobei der dritte Bereich (13) vom ersten Bereich (11) und vom zweiten Bereich (12) getrennt ist; die zweite Übertragungsleitung (70), die zweite Übertragungsschicht (43), die erste Übertragungsleitung (60) und der dritte Bereich (13) einen zweiten Strompfad (L2) bilden; der zweite Strompfad (L2) parallel zum ersten Strompfad (L1) verläuft und diesem gegenüberliegt.

2. Leistungsvorrichtung (1, 2) nach Anspruch 1, ferner umfassend:
einen ersten Gate-Widerstand (101), der elektrisch mit dem ersten Leistungsbauelement (20) verbunden ist; und
einen zweiten Gate-Widerstand (102), der elektrisch mit dem zweiten Leistungsbauelement (30) verbunden ist.

3. Leistungsvorrichtung (1, 2) nach Anspruch 2, wobei der dritte Bereich (13), die erste Übertragungsschicht (42) und das erste Leistungsbauelement (20) einen dritten Strompfad (L3) bilden; der dritte Strompfad (L3) und der erste Strompfad (L1) in Reihe geschaltet sind und in dieselbe Richtung verlaufen; der erste Gate-Widerstand (101) auf der zweiten Übertragungsschicht (43) angeordnet ist.

## Revendications

1. Un appareil de puissance (1, 2) comprenant :
un substrat (10, 10') comprenant une première zone (11) et une deuxième zone (12) séparées l'une de l'autre ;
un premier composant de puissance (20) disposé sur la première zone (11) ;
un deuxième composant de puissance (30) disposé sur la deuxième zone (12) ; et
une carte de connexion (40, 40') disposée entre la première zone (11) et la deuxième zone (12), et connectée électriquement respectivement au premier composant de puissance (20) et à la deuxième zone (12) ;
dans lequel la carte de connexion (40, 40') comprend une couche de matériau de base (41), une première couche de transmission (42) et une deuxième couche de transmission (43) empilées les unes sur les autres ; la couche de matériau de base (41) est prise en sandwich entre la première couche de transmission (42) et la deuxième couche de transmission (43) ; la première couche de transmission (42) est reliée électriquement respectivement au premier composant de puissance (20) et à la deuxième zone (12) ; le substrat (10, 10') comprend en outre une troisième zone (13) ; la troisième zone (13) est séparée de la première zone (11) et de la deuxième zone (12) ; le premier composant de puissance (20), la première couche de transmission (42), la deuxième zone (12) et le deuxième composant de puissance (30) forment un premier chemin de courant (L1) ;
**caractérisé en ce que** l'appareil de puissance (1, 2) comprend en outre :
une deuxième ligne de transmission (60) connectée électriquement à une extrémité de la deuxième couche de transmission (43) et à la troisième zone (13) du substrat (10, 10') ; et
une deuxième ligne de transmission (70) connectée électriquement à l'autre extrémité de la deuxième couche de transmission (43) et au deuxième composant de puissance (30),
dans lequel la troisième zone (13) est séparée de la première zone (11) et de la deuxième zone (12) ; le deuxième composant de puissance (30), la deuxième ligne de transmission (70), la deuxième couche de transmission (43), la première ligne de transmission (60) et la troisième zone (13) forment un deuxième chemin de courant (L2) ; le deuxième chemin de courant (L2) est parallèle et opposé au premier chemin de courant (L1).

2. L'appareil de puissance (1, 2) selon la revendication 1, comprenant en outre :
une première résistance de grille (101) connectée électriquement au premier composant de puissance (20) ; et
une deuxième résistance de grille (102) connectée électriquement au deuxième composant de puissance (30).

3. L'appareil de puissance (1, 2) selon la revendication 2, dans lequel la troisième zone (13), la première couche de transmission (42) et le premier composant de puissance (20) forment un troisième chemin de courant (L3) ; le troisième chemin de courant (L3) et le premier chemin de courant (L1) sont en série et dans le même sens ; la première résistance de grille (101) est disposée sur la deuxième couche de transmission (43).
